# EUROPÄISCHE PATENTSCHRIFT

(11) **EP 2 301 312 B1**
(45) Veröffentlichungstag und Bekanntmachung des Hinweises auf die Patenterteilung: **21.03.2018**
(21) Anmeldenummer: 09768824.6
(22) Anmeldetag: 23.06.2009
(51) Int. Cl.: H05K 5/06, H05K 5/00, B23P 11/00, B21D 39/00

(54) **VERFAHREN ZUR HERSTELLUNG EINER DICHTEN, FORMSCHLÜSSIGEN VERBINDUNG**
METHOD FOR PRODUCING A TIGHT, FORM-FITTING CONNECTION
PROCÉDÉ DE RÉALISATION D'UNE LIAISON ÉTANCHE À ENGAGEMENT GÉOMÉTRIQUE

(30) Priorität: 28.06.2008 DE 102008030775
(43) Veröffentlichungstag der Anmeldung: 30.03.2011
(73) Patentinhaber: Conti Temic Microelectronic GmbH, 90411 Nürnberg (DE)
(72) Erfinder: EGLINGER, Markus, Dr., 48188 Canton, MI (US); GRAMANN, Matthias, 77871 Renchen (DE)
(74) Vertreter: Bonn, Roman Klemens
(86) Internationale Anmeldenummer: PCT/DE2009/000865
(87) Internationale Veröffentlichungsnummer: WO 2009/155900

(56) Entgegenhaltungen:
- EP-A- 1 603 377
- EP-A- 1 995 121
- WO-A-2008/027018
- FR-A- 2 500 980
- GB-A- 1 398 766
- US-A- 3 910 212

## Beschreibung

Die Erfindung betrifft ein Verfahren zur Herstellung einer dichten, formschlüssigen Verbindung zwischen einem Gehäusedeckel und einem Gehäusekörper gemäß dem Oberbegriff des Anspruchs 1.

Bei der Herstellung von Steuergerätegehäusen, insbesondere von Steuergeräten für die Automobilindustrie, wird der Gehäusedeckel mit dem Gehäusekörper in der Regel mittels Kleben, Nieten oder Schrauben verbunden. Dabei wird normalerweise in einem ersten Arbeitsgang der Gehäusedeckel am Gehäusekörper mittels eines geeigneten Positionierwerkzeugs positioniert. Anschließend wird die Verbindung zwischen dem Gehäusedeckel und dem Gehäusekörper mittels eines weiteren Werkzeugs hergestellt.

Die GB-A-1398766 beschreibt ein Verfahren zur Herstellung einer dichten, formschlüssigen Verbindung zwischen einem Gehäusedeckel und einem Gehausekörper, wobei am Rand des Gehäusedeckels Deckellaschen angeformt sind, und am Rand des Gehäusekörpers Bereiche angeordnet sind, die die Deckellaschen aufnehmen, wobei nach dem Positionieren des Gehäusedeckels am Gehäusekörper die Deckellaschen zur Herstellung der dichten, formschlüssigen Verbindung zwischen dem Gehäusedeckel und dem Gehausekörper in den Bereichen des Gehäusekörpers verformt werden.

Es ist daher die Aufgabe der Erfindung, ein einfaches und kostengünstiges Verfahren zu schaffen, das es ermöglicht, in einer automatisierten Produktion einen Gehäusedeckel mit einem Gehäusekörper zu verbinden.

Diese Aufgabe wird erfindungsgemäß durch ein Verfahren mit den Merkmalen des Anspruchs 1 gelöst.

Das erfindungsgemäße Verfahren beschreibt die Herstellung einer dichten, formschlüssigen Verbindung zwischen einem Gehäusedeckel und einem Gehäusekörper, zum Beispiel eines Steuergerätgehäuses, wie es in der Automobilindustrie zur Anwendung kommt. Dabei sind am Rand des Gehäusedeckels Deckellaschen angeformt. Am Rand des Gehäusekörpers sind Bereiche angeordnet, die die Deckellaschen aufnehmen können. Die Bereiche am Rand des Gehäusekörpers können als durchgehende Ausnehmungen oder als Sacklöcher ausgestaltet sein. Vorzugsweise wird die Positionierung des Gehäusedeckels am Gehäusekörper und das Herstellen der dichten, formschlüssigen Verbindung in einem einzigen Arbeitsgang mit einem einzigen Werkzeug bewerkstelligt wird. Dabei werden nach dem Positionieren des Gehäusedeckels am Gehäusekörper die Deckellaschen zur Herstellung der dichten, formschlüssigen Verbindung zwischen dem Gehäusedeckel und dem Gehäusekörper in den Bereichen des Gehäusekörpers verformt. Dadurch wird das Verfahren durch die Einsparung von Werkzeugen und separaten Verbindungsmitteln wie Schrauben oder Nieten beschleunigt und kostengünstiger.

Zur Erhöhung der Dichtheit der Verbindung, kann zwischen dem Gehäusedeckel und dem Gehäusekörper vorteilhafterweise eine umlaufende Dichtung, zum Beispiel aus Polyethylen angeordnet werden. Dabei kann die Dichtung wahlweise am Gehäusedeckel oder am Gehäusekörper, je nach Einbaulage, angeordnet sein. Die Dichtung kann insbesondere angespritzt sein oder als Einlegedichtung ausgeführt sein.

Weitere Vorteile und Merkmale der Erfindung ergeben sich aus der nachfolgenden Beschreibung eines Ausführungsbeispiels der Erfindung anhand der Zeichnung. Es zeigt:
- Fig.1 bis 3: Herstellen der Verbindung, wobei am Rand eines Gehäusekörpers eine durchgehende Ausnehmung ausgestaltet ist,
- Fig. 4 und 5: Herstellen der Verbindung, wobei am Rand des Gehäusekörpers ein Sackloch ausgestaltet ist, und
- Fig. 6: einen Gehäusedeckel mit Deckellaschen.

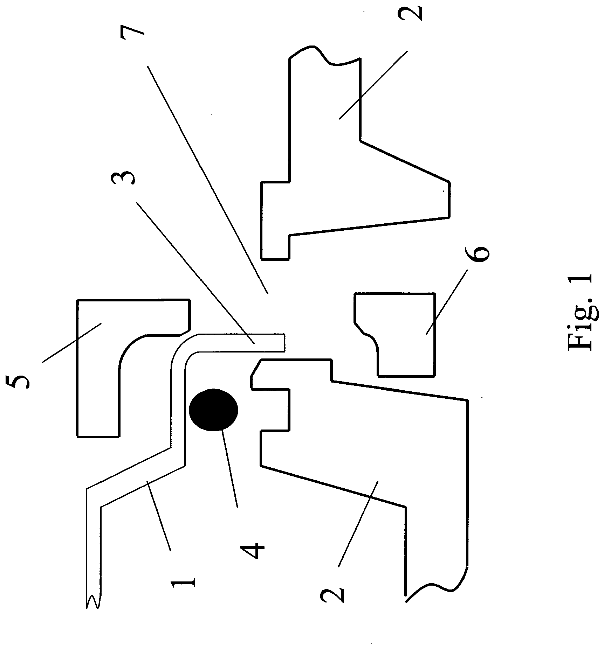

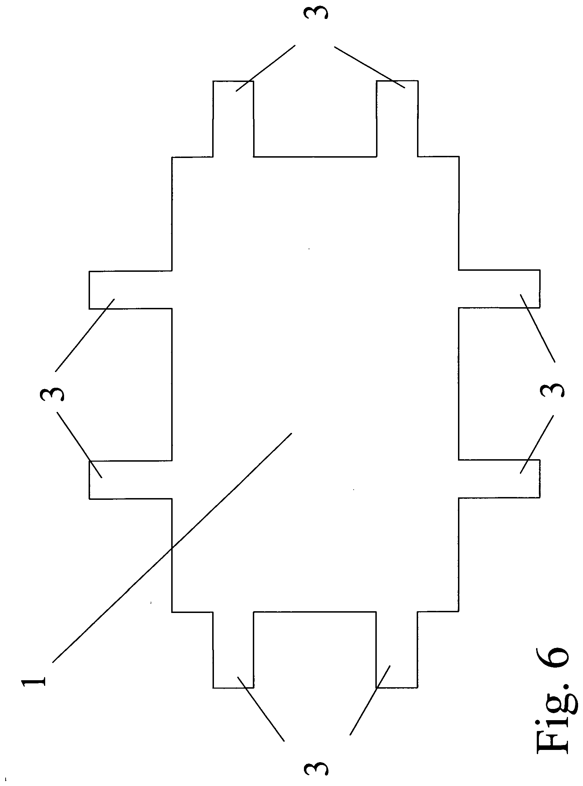

Fig. 1 zeigt ein Gehäuse aus einem Gehäusedeckel (1) und einem Gehäusekörper (2). Am Rand des Gehäusedeckels (1) ist eine Vielzahl von Deckellaschen (3) angeformt, wie auch in Fig. 6 dargestellt. Am Rand des Gehäusekörpers (2) sind eine Vielzahl von Bereichen angeordnet, wobei jeweils ein Bereich eine Deckellasche (3) aufnehmen kann. Der Bereich ist in Fig. 1 als durchgehende Ausnehmung (7) ausgeführt. Die Deckellasche (3) ragt bereits teilweise in die Ausnehmung (7) hinein. Das Werkzeug (5, 6) ist zweiteilig, aus einem Positionierwerkzeug (5) und einem Verformwerkzeug (6) ausgelegt.

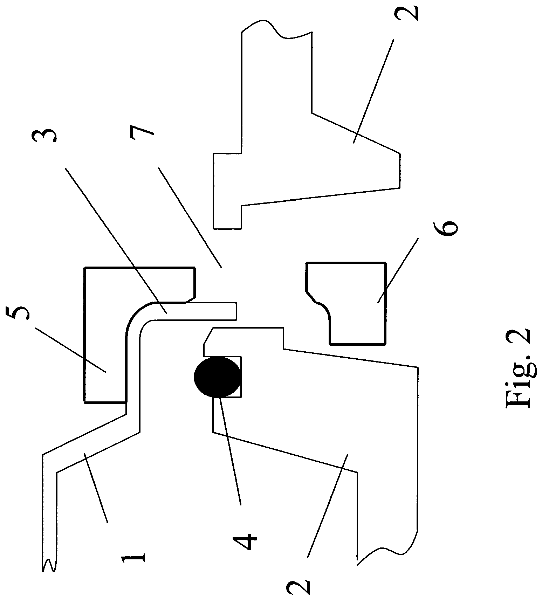

In Fig. 2 ist eine umlaufende O-Ring Dichtung (4) in eine entsprechende Nut am Gehäusekörper (2) eingelegt und das Positionierwerkzeug (5) hat den Gehäusedeckel (1) mittels der Deckelaschen (3) positioniert.

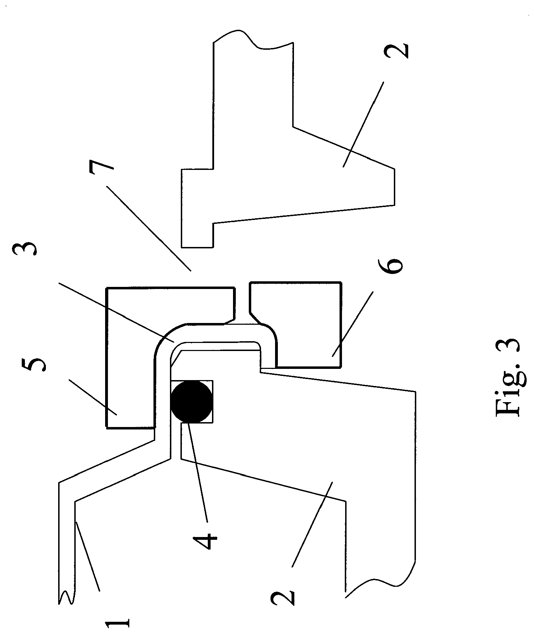

In Fig. 3 ist der Gehäusedeckel (1) am Gehäusekörper (2) durch das Positionierwerkzeug (5) positioniert. Gleichzeitig hat das Verformwerkzeug (6) die Deckellasche (3) um den Rand des Gehäusekörpers (2) gebördelt. Zwischen dem Gehäusedeckel (1) und dem Gehäusekörper (2) ist damit eine dichte, formschlüssige Verbindung in einem einzigen Arbeitsgang mit einem einzigen Werkzeug (5, 6) hergestellt.

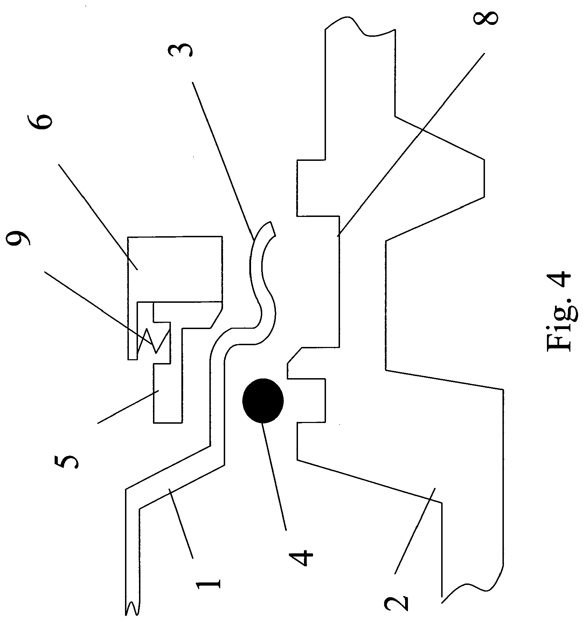

Fig. 4 zeigt die Ausgangsituation wie in Fig. 1, jedoch ist hier der Bereich am Rand des Gehäusekörpers (2) zur Aufnahme einer Deckellasche (3) als Sackloch (8) ausgebildet. Wie in Fig. 4 ist hier die Deckellasche (3) bereits vorgeformt.

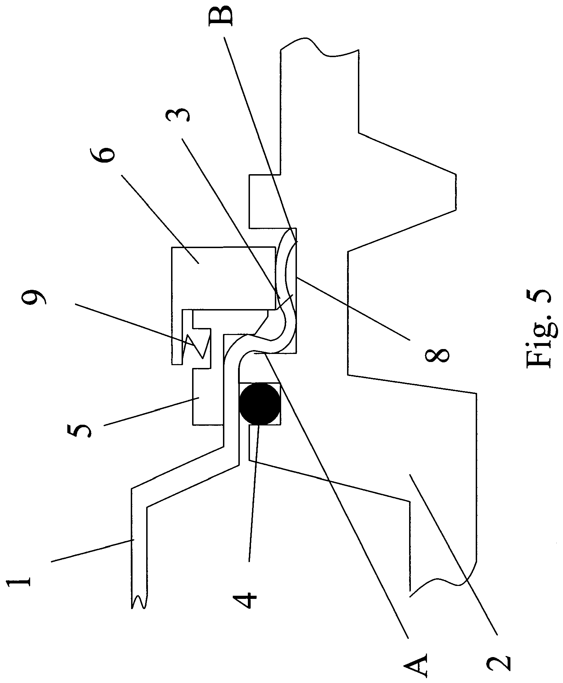

In Fig. 5 ist die O-Ring Dichtung (4) in eine entsprechende Nut am Gehäusekörper (2) eingelegt. Der Gehäusedeckel (1) ist in einem Arbeitsgang durch das Positionierwerkzeug (5) am Gehäusekörper (2) positioniert und die Deckellasche (3) ist in dem Sackloch (8) formschlüssig verpresst. Insbesondere kann die Richtung der Anpresskraft durch Variation des Höhenunterschiedes der Punkte A und B im Sackloch (8) erreicht werden. Damit ist eine dichte, formschlüssige Verbindung zwischen dem Gehäusedeckel (1) und dem Gehäusekörper (2) in einem einzigen Arbeitsgang mit einem einzigen Werkzeug (5, 6) hergestellt.

Vorteilhafterweise sind Positionierwerkzeug (5) und Verformwerkzeug (6), wie in Fig. 4 und 5 angedeutet, zum Beispiel durch die Feder (9) gefedert. Dadurch werden insbesondere grobe Toleranzen der einzelnen Gehäuseteile (1, 2, 3, 7, 8) aufgefangen, was zu einer Kosteneinsparung vor allem am Material führt. Ein weiterer Vorteil des Verfahrens ist, dass durch den Wegfall von Verbindungsmitteln, wie Nieten oder Schrauben, die Wandstärke des Gehäusedeckels (1) gering gehalten werden kann.

Fig. 6 zeigt einen Gehäusedeckel (1) mit je zwei Deckellaschen (3) an einer Seite. Die Anzahl der Deckellaschen (3) pro Seite kann je nach Bedarf variieren.

## Patentansprüche

1. Verfahren zur Herstellung einer dichten, formschlüssigen Verbindung zwischen einem Gehäusedeckel (1) und einem Gehäusekörper (2) eines Gehäuses, wobei am Rand des Gehäusedeckels (1) Deckellaschen (3) angeformt sind, und am Rand des Gehäusekörpers (2) Bereiche (7, 8) angeordnet sind, die die Deckellaschen (3) aufnehmen , **dadurch gekennzeichnet, dass** die Positionierung des Gehäusedeckels (1) am Gehäusekörper (2) und das Herstellen der dichten, formschlüssigen Verbindung in einem einzigen Arbeitsgang mit einem einzigen Werkzeug (5, 6) bewerkstelligt wird, wobei das Werkzeug (5, 6) zweiteilig, aus einem Positionierwerkzeug (5) und einem Verformwerkzeug (6) ausgelegt ist und beide Werkzeuge (5, 6) gleichzeitig arbeiten, und wobei nach dem Positionieren des Gehäusedeckels (1) am Gehäusekörper (2) die Deckellaschen (3) zur Herstellung der dichten, formschlüssigen Verbindung zwischen dem Gehäusedeckel (1) und dem Gehäusekörper (2) in den Bereichen (7, 8) des Gehäusekörpers (2) verformt werden.

2. Verfahren nach Anspruch 1, **dadurch gekennzeichnet, dass** die Bereiche als durchgehende Ausnehmungen (7) am Rand des Gehäusekörpers (2) ausgestaltet sind und die Deckellasche (3) um den Rand des Gehäusekörpers (2) umgebördelt wird.

3. Verfahren nach Anspruch 1, **dadurch gekennzeichnet, dass** die Bereiche als Sacklöcher (8) am Rand des Gehäusekörpers (2) ausgestaltet sind und die Deckellasche (3) im Sackloch (8) verpresst wird.

4. Verfahren nach einem der vorangehenden Ansprüche, **dadurch gekennzeichnet, dass** zwischen dem Gehäusedeckel (1) und dem Gehäusekörper (2) eine umlaufende Dichtung (4) angeordnet wird.

5. Verfahren nach Anspruch 4, **dadurch gekennzeichnet, dass** die umlaufende Dichtung (4) am Gehäusedeckel (1) angeordnet wird.

6. Verfahren nach Anspruch 4, **dadurch gekennzeichnet, dass** die umlaufende Dichtung (4) am Gehäusekörper (2) angeordnet wird.

## Claims

1. Method for producing a leaktight, form-fitting connection between a housing cover (1) and a housing body (2) of a housing, wherein cover tabs (3) are integrally formed at the periphery of the housing cover (1), and regions (7, 8) which receive the cover tabs (3) are arranged at the periphery of the housing body (2), **characterized in that** the positioning of the housing cover (1) on the housing body (2) and the production of the leaktight, form-fitting connection are effected in a single operation with a single tool (5, 6), wherein the tool (5, 6) is designed in a two-part manner, from a positioning tool (5) and a deforming tool (6), and the two tools (5, 6) work simultaneously, and wherein, after the housing cover (1) has been positioned on the housing body (2), the cover tabs (3) are deformed to produce the leaktight, form-fitting connection between the housing cover (1) and the housing body (2) in the regions (7, 8) of the housing body (2).

2. Method according to Claim 1, **characterized in that** the regions are configured as continuous recesses (7) at the periphery of the housing body (2) and the cover tab (3) is flanged about the periphery of the housing body (2).

3. Method according to Claim 1, **characterized in that** the regions are configured as blind holes (8) in the periphery of the housing body (2) and the cover tab (3) is pressed in the blind hole (8).

4. Method according to one of the preceding claims, **characterized in that** an encircling seal (4) is arranged between the housing cover (1) and the housing body (2).

5. Method according to Claim 4, **characterized in that** the encircling seal (4) is arranged on the housing cover (1).

6. Method according to Claim 4, **characterized in that** the encircling seal (4) is arranged on the housing body (2).

## Revendications

1. Procédé de fabrication d'une liaison étanche à engagement géométrique entre un couvercle de boîtier (1) et un corps de boîtier (2) d'un boîtier, des pattes de couvercle (3) étant façonnées au niveau du bord du couvercle de boîtier (1) et des zones (7, 8) qui reçoivent les pattes de couvercle (3) étant disposées au niveau du bord du corps de boîtier (2), **caractérisé en ce que** le positionnement du couvercle de boîtier (1) sur le corps de boîtier (2) et l'établissement de la liaison étanche à engagement géométrique sont effectués en une seule passe de travail avec un seul outil (5, 6), l'outil (5, 6) étant réalisé en deux parties, à partir d'un outil de positionnement (5) et d'un outil de déformation (6) et les deux outils (5, 6) fonctionnant simultanément, et après le positionnement du couvercle de boîtier (1) sur le corps de boîtier (2), les pattes de couvercle (3), pour établir la liaison étanche à engagement géométrique entre le couvercle de boîtier (1) et le corps de boîtier (2), étant déformées dans les zones (7, 8) du corps de boîtier (2).

2. Procédé selon la revendication 1, **caractérisé en ce que** les zones sont configurées sous forme d'évidements continus (7) au niveau du bord du corps de boîtier (2) et la patte de couvercle (3) est repliée autour du bord du corps de couvercle (2).

3. Procédé selon la revendication 1, **caractérisé en ce que** les zones sont configurées sous forme de trous borgnes (8) au niveau du bord du corps de boîtier (2) et la patte de couvercle (3) est pressée dans le trou borgne (8).

4. Procédé selon l'une quelconque des revendications précédentes, **caractérisé en ce qu'**entre le couvercle de boîtier (1) et le corps de boîtier (2) est disposé un joint d'étanchéité périphérique (4).

5. Procédé selon la revendication 4, **caractérisé en ce que** le joint d'étanchéité périphérique (4) est disposé au niveau du couvercle de boîtier (1).

6. Procédé selon la revendication 4, **caractérisé en ce que** le joint d'étanchéité périphérique (4) est disposé au niveau du corps de boîtier (2).
